(19) **Europäisches Patentamt / European Patent Office / Office européen des brevets**

(11) **EP 4 764 509 A1**

(12) # DEMANDE DE BREVET EUROPEEN

(43) Date de publication:
**24.06.2026 Bulletin 2026/26**

(21) Numéro de dépôt: **25224142.7**

(22) Date de dépôt: **16.12.2025**

(51) Classification Internationale des Brevets (IPC):
***G01R 15/20*** *(2006.01)*

(52) Classification Coopérative des Brevets (CPC):
**G01R 15/207; G01R 15/202**

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**GE KH LA MA MD TN**

(30) Priorité: **20.12.2024 FR 2414889**

(71) Demandeurs:
• **SNCF Réseau**
**93200 Saint-Denis (FR)**

• **Kapteos**
**73800 Sainte-Hélène-du-Lac (FR)**

(72) Inventeurs:
• **DUMONT, Erwan**
**92700 COLOMBES (FR)**
• **DUVILLARET, Lionel**
**73000 ALBERTVILLE (FR)**
• **CHEVRIER-GROS, Guillaume**
**73200 ALBERTVILLE (FR)**

(74) Mandataire: **Argyma**
**14 Boulevard de Strasbourg**
**31000 Toulouse (FR)**

(54) **SYSTÈME DE MESURE DE L'INTENSITÉ D'UN COURANT ÉLECTRIQUE DANS UN CÂBLE ÉLECTRIQUE ET PROCÉDÉ DE MESURE ASSOCIÉ**

(57) Un système de mesure (1) d'une intensité de courant électrique circulant dans un câble électrique à tester (CT), le système de mesure (1) comprenant : un organe de support (2) s'étendant, dans un plan transversal (J, K), selon une plage angulaire inférieure ou égale à 180° autour du câble à tester (CT) ; au moins trois dispositifs de mesure (31, 32, 33) montés sur l'organe de support (2), chaque dispositif de mesure (3i) possédant une position angulaire propre et étant configuré pour mesurer une composante ortho-radiale du champ magnétique émis par le câble à tester (CT), la composante ortho-radiale ayant une amplitude définie selon la formule $Si(\theta i) = C + A1 \cos(\theta i + \delta\theta 1) + \epsilon i$ ; et un calculateur (4) configuré pour déterminer le premier paramètre (C) et la valeur d'intensité (I) du courant électrique traversant le câble à tester (CT) à partir de l'équation de courant : $I = Q C$.

[Fig. 3]

FIG. 3

EP 4 764 509 A1

**Description**

## DOMAINE TECHNIQUE

La présente invention concerne le domaine de la mesure de l'intensité d'un courant électrique circulant dans un câble électrique. L'invention s'applique en particulier pour la mesure de l'intensité d'un courant électrique dans une caténaire d'une voie ferrée.

Il est connu de mesurer l'intensité d'un courant électrique qui traverse un câble électrique afin de s'assurer de son bon fonctionnement. Pour cela, on connaît en particulier des systèmes de mesure dits « sans contact » qui utilisent des capteurs de champ magnétique, par exemple des capteurs à effet Hall. Pour déterminer une valeur d'intensité de courant électrique fiable, un tel système de mesure comprend généralement une pluralité de capteurs répartis autour du câble à tester.

Cependant, de tels systèmes de mesure, qui nécessitent de s'étendre autour du câble à tester, ne peuvent être montés par exemple sur des câbles positionnés à proximité d'une paroi qui empêche le positionnement des capteurs. De même, les lignes aériennes connues sous la désignation de « caténaire » et destinées à alimenter électriquement un véhicule ferroviaire doivent pour cela être mises en contact avec un pantographe monté sur le véhicule ferroviaire. Le système de mesure ne peut alors pas s'étendre sous le câble à tester.

Dans l'art antérieur, on connaît également des systèmes de mesure qui s'étendent uniquement partiellement autour du câble à tester, par exemple en regard d'une moitié du câble à tester. Cependant, de tels systèmes utilisent généralement un générateur de signaux ou des bobines magnétiques ou bien nécessitent l'ajout d'un moteur, ce qui les rend complexes à mettre en œuvre et leur confère une masse et un encombrement importants. Cela présente un inconvénient important en particulier pour la mesure d'une intensité de courant électrique traversant une caténaire de voie ferrée, en suspension entre deux poteaux.

De plus, il est parfois nécessaire de mesurer l'intensité du courant électrique dans un câble à tester autour duquel se trouvent un ou plusieurs autres câbles électriques qui peuvent perturber la mesure. La mesure de courant est alors peu fiable.

L'invention vise ainsi à éliminer au moins certains de ces inconvénients en proposant un système de mesure de l'intensité d'un courant électrique circulant dans un câble électrique fiable et peu encombrant. L'invention vise en particulier un système de mesure qui peut être utilisé sur une caténaire d'une voie ferrée en permettant le passage d'un pantographe tout en s'assurant d'une mesure précise même en cas de présence d'un câble électrique perturbateur à proximité.

De manière incidente, on connait des documents FR3143130A1, CN110412339A, US20030151406A1 et US2024125819A1, des dispositifs de mesure de l'intensité du courant électrique dans un câble électrique comprenant plusieurs capteurs de champ magnétique.

## PRESENTATION DE L'INVENTION

L'invention concerne un système de mesure d'une intensité de courant électrique circulant dans un câble électrique à tester, ci-après désigné câble à tester, le système de mesure comprenant :

- un organe de support comprenant une gorge s'étendant longitudinalement selon un axe principal et configurée pour permettre le passage du câble à tester, l'organe de support définissant un plan transversal à l'axe principal qui comprend une zone de test, l'organe de support s'étendant, dans le plan transversal, selon une plage angulaire autour de la zone de test inférieure ou égale à 180°, le câble à tester étant configuré pour s'étendre dans la zone de test lors de son utilisation,

- au moins trois dispositifs de mesure configurés pour mesurer un champ magnétique émis par le câble à tester, les dispositifs de mesure étant montés sur l'organe de support dans le plan transversal et répartis angulairement à une même distance radiale de la zone de test,

- chaque dispositif de mesure possédant une position angulaire propre dans le plan transversal par rapport à la zone de test, chaque dispositif de mesure étant configuré pour mesurer une composante ortho-radiale du champ magnétique émis par le câble à tester, la composante ortho-radiale ayant une amplitude $S_i$ définie selon la formule suivante : $S_i(\theta_i) = C + A_1 \cos(\theta_i + \delta\theta_1) + \varepsilon_i$ dans laquelle :

    • C est un premier paramètre à déterminer,

    • $A_1$ est un deuxième paramètre à déterminer, et

- • δθ1 est un troisième paramètre à déterminer,

- un calculateur relié à chaque dispositif de mesure, le calculateur étant configuré pour :

  - • lorsque εi est négligeable au regard du premier paramètre et du deuxième paramètre, déterminer le premier paramètre, le deuxième paramètre et le troisième paramètre à partir des composantes ortho-radiales mesurées par les dispositifs de mesure à un instant donné, et

  - • déterminer la valeur d'intensité du courant électrique traversant le câble à tester à partir :

    - du premier paramètre déterminé, et

    - de l'équation de courant : I = Q C, dans laquelle Q est une constante prédéterminée.

Le système de mesure selon l'invention permet de mesurer de manière simple et efficace l'intensité d'un courant électrique dans un câble électrique au moyen d'une pluralité de dispositifs de mesure d'un champ magnétique. Une seule série de dispositifs de mesure de même nature permet un système de mesure simple de conception et peu volumineux.
La forme de l'organe de support qui s'étend sur une amplitude au maximum égale à 180° autour de la zone de test permet la mesure d'intensité de courant sur des câbles électriques autour desquels il n'est pas possible de monter un système qui entoure entièrement le câble à tester. En particulier, la mesure de courant peut facilement être réalisée sur une caténaire de voie ferrée tout en permettant le passage d'un pantographe, de même que sur un câble monté par exemple contre une paroi.
De plus, grâce à la pluralité de dispositifs de mesure répartis autour de la zone de test, la mesure de courant est fiable et ne présente pas de risque d'être perturbée, même en cas de présence de câbles électriques dans l'environnement du câble à tester.
Dans une forme de réalisation, le système de mesure comprend au moins cinq dispositifs de mesure configurés pour mesurer un champ magnétique émis par le câble à tester,

- l'amplitude de la composante ortho-radiale mesurée par chaque dispositif de mesure étant définie selon la formule suivante : $S_i(\theta_i) = C + A_1 \cos(\theta_i + \delta\theta_1) + \varepsilon_i$ et $\varepsilon_i$ étant égal à $A_2 \cos(2\theta_i + \delta\theta_2)$ dans laquelle :

  - • A2 est un quatrième paramètre à déterminer, et

  - • δθ2 est un cinquième paramètre à déterminer,

- le calculateur étant configuré pour :

  - • lorsque εi est non-négligeable au regard du premier paramètre et du deuxième paramètre, déterminer le premier paramètre, le deuxième paramètre, le troisième paramètre, le quatrième paramètre et le cinquième paramètre à partir des composantes ortho-radiales mesurées par les dispositifs de mesure à un instant donné, et

  - • déterminer la valeur d'intensité du courant électrique traversant le câble à tester.

L'intensité du courant circulant dans le câble à tester peut facilement être mesurée de manière fiable, même en présence de câbles perturbateurs à proximité du câble à tester. Les cinq dispositifs de mesure permettent de fournir cinq équations et cinq amplitudes, qui permettent de déterminer les cinq paramètres à déterminer.
Selon un aspect, les dispositifs de mesure sont répartis angulairement de manière uniforme sur l'organe de support autour de la zone à tester. Une telle répartition permet une mesure optimale de l'intensité du courant électrique quelle que soit la position d'un câble électrique perturbateur dans l'environnement du câble à tester. Une répartition uniforme permet également d'harmoniser les mesures du champ magnétique.
Dans une forme de réalisation, le système de mesure comprend un nombre de dispositifs de mesure compris entre six et neuf, permettant de s'assurer d'une mesure fiable, tout en assurant une redondance en cas de défaillance de l'un des dispositifs de mesure par exemple.
De manière préférée, la zone de test possédant une forme circulaire possédant un rayon extérieur, la distance radiale entre chaque dispositif de mesure et le centre de la zone de test est comprise entre deux et cinq fois le rayon extérieur de la zone de test. Par la distance radiale entre le dispositif de mesure et le centre de la zone de test, on entend la distance radiale entre le barycentre du dispositif de mesure et le centre de la zone de test. Une telle distance radiale permet une réception fiable du champ magnétique émis par le câble à tester, sans risque d'interférence entre les dispositifs de mesure.

Selon un aspect, l'organe de support présente une symétrie angulaire par rapport à la zone de test, de manière à permettre un positionnement symétrique des dispositifs de mesure par rapport à la zone de test. L'organe de support possède par exemple une section en forme de demi-disque. Par « symétrie angulaire », on entend que l'organe de support s'étend à une même distance radiale de la zone de test afin de ne pas perturber le champ magnétique. Cela permet de déterminer les paramètres à déterminer de manière fiable en corrélant au moins les trois équations d'amplitude.

Dans une forme de réalisation préférée, chaque dispositif de mesure est un capteur à effet Hall, permettant l'utilisation de capteurs connus, simples d'utilisation et peu encombrants.

Selon un aspect, chaque dispositif de mesure comprend un organe d'amplification du signal généré, permettant de s'assurer d'une réception fiable par le calculateur.

De manière préférée, chaque dispositif de mesure comprend un organe de filtrage configuré pour supprimer des harmoniques des signaux générés, permettant de limiter tout risque de parasitage du signal.

L'invention concerne également un ensemble d'un câble à tester et d'un système de mesure tel que décrit précédemment, l'organe de support étant monté autour du câble à tester de manière à mesurer l'intensité du courant électrique traversant le câble à tester.

Enfin, l'invention porte sur un procédé de mesure d'une intensité du courant électrique circulant dans un câble à tester au moyen du système de mesure tel que décrit précédemment, un câble à tester étant monté dans la zone à tester, le procédé comprenant les étapes consistant à :

- mesurer, à un instant donné, par chaque dispositif de mesure, une composante ortho-radiale du champ magnétique émis par le câble à tester,

- déterminer au moins le premier paramètre, le deuxième paramètre et le troisième paramètre à partir des composantes ortho-radiales mesurées ayant une amplitude définie selon la formule suivante : $S_i(\theta_i) = C + A_1 \cos(\theta_i + \delta\theta_1) + \varepsilon_i$, et

- déterminer la valeur d'intensité du courant électrique traversant le câble à tester à partir du premier paramètre et de l'équation de courant : $I = Q C$, dans laquelle Q est une constante prédéterminée.

Selon un aspect, lorsque $\varepsilon_i$ est non négligeable au regard du premier paramètre et du deuxième paramètre, l'étape de détermination détermine le premier paramètre, le deuxième paramètre, le troisième paramètre, le quatrième paramètre et le cinquième paramètre.

**PRESENTATION DES FIGURES**

L'invention sera mieux comprise à la lecture de la description qui va suivre, donnée à titre d'exemple, et se référant aux figures suivantes, données à titre d'exemples non limitatifs, dans lesquelles des références identiques sont données à des objets semblables.

La figure 1 est une représentation schématique d'un câble à tester et d'un système de mesure selon une première forme de réalisation de l'invention.

La figure 2 est une vue du système de mesure dans un plan de projection orthogonal à l'axe selon lequel s'étend le câble à tester.

La figure 3 est une vue rapprochée d'un organe de support et de dispositifs de mesure du système de mesure de la figure 2 en présence d'un autre câble.

La figure 4 est une représentation schématique d'un système de mesure selon une deuxième forme de réalisation de l'invention.

La figure 5 est un schéma des étapes d'un procédé de mesure selon un mode de mise en œuvre de l'invention.

Il faut noter que les figures exposent l'invention de manière détaillée pour mettre en œuvre l'invention, lesdites figures pouvant bien entendu servir à mieux définir l'invention le cas échéant.

## DESCRIPTION DETAILLEE DE L'INVENTION

L'invention concerne un système de mesure de l'intensité d'un courant électrique traversant un câble électrique à tester. L'invention trouve un intérêt particulier pour la mesure de l'intensité d'un courant électrique circulant dans une caténaire de voie ferrée.

Comme cela est connu, pour permettre la circulation d'un véhicule ferroviaire, celui-ci doit être alimenté électriquement. Pour cela, une ligne aérienne connue sous la désignation de « caténaire » s'étend au dessus de la voie ferrée et est configurée pour être mise en contact avec au moins un pantographe du véhicule ferroviaire. La caténaire permet d'alimenter électriquement le véhicule ferroviaire. Pour s'assurer d'un fonctionnement optimal du véhicule ferroviaire, il est nécessaire que le courant électrique qui traverse la caténaire soit à une intensité prédéterminée. Pour cela, il est nécessaire de mesurer cette intensité électrique pour permettre, le cas échéant, la mise en place de mesures spécifiques, par exemple une opération de maintenance ou une adaptation du courant électrique d'alimentation.

L'invention va être décrite par la suite pour la mesure de l'intensité d'un courant électrique circulant dans une caténaire de voie ferrée, mais il va de soi que le système de mesure selon l'invention peut tout aussi bien être utilisé pour la mesure d'une intensité de courant électrique circulant dans tout type de câble électrique.

Par souci de concision, on désigne par la suite par « câble à tester », le câble électrique à tester (par exemple la caténaire) dans lequel il est nécessaire de mesurer l'intensité du courant électrique.

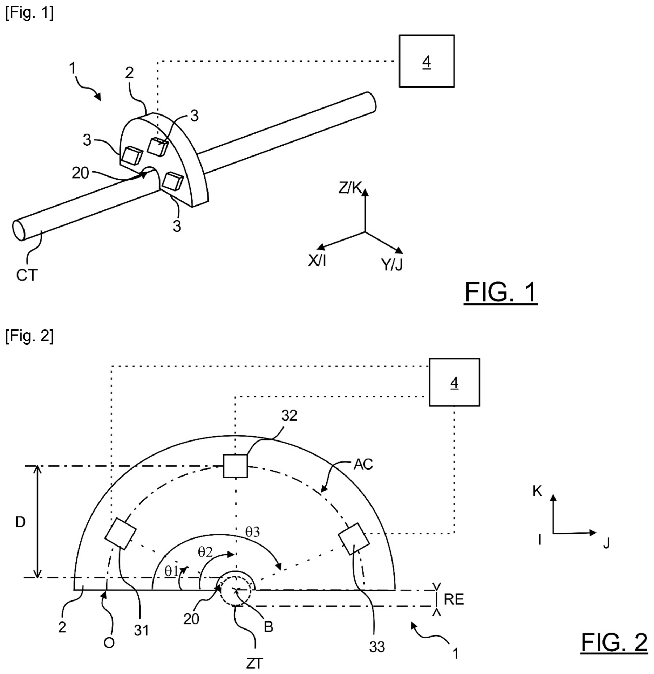

En référence à la figure 1, le câble à tester CT s'étend longitudinalement selon un axe X, latéralement selon un axe Y et verticalement selon un axe Z, de manière à former un repère orthogonal (X, Y, Z). Par la suite, on définit le sens de l'axe vertical Z qui s'étend du bas vers le haut, comme représenté sur la figure 1.

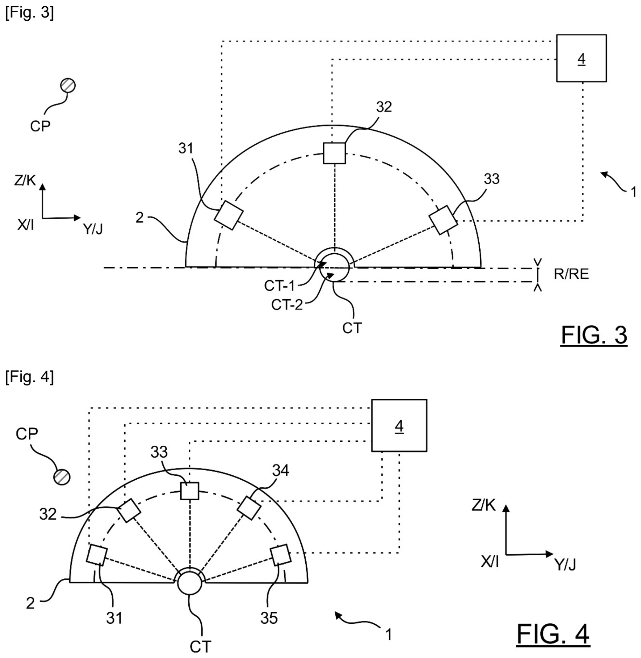

Le câble à tester CT possède, dans cet exemple, la forme d'un cylindre circulaire droit. A ce titre, le câble à tester CT possède, dans un plan de coupe (Y, Z), une section circulaire comme représenté sur la figure 3. Il va de soi que le câble à tester CT pourrait alternativement posséder une forme différente.

Dans cet exemple, en référence à la figure 3, dans le plan de coupe (Y, Z), le câble à tester CT possède un rayon R prédéterminé. De plus, on définit, dans ce plan de coupe (Y, Z) et selon l'axe vertical Z, orienté du bas vers le haut, une moitié supérieure CT-1 et une moitié inférieure CT-2 du câble à tester CT.

Il va dorénavant être décrit un système de mesure 1 de l'intensité du courant électrique traversant le câble à tester CT selon une forme de réalisation de l'invention. Le système de mesure 1 permet avantageusement une mesure de courant électrique sans contact.

En référence à la figure 1, le système de mesure 1 comprend un organe de support 2 configuré pour s'étendre, dans une configuration d'utilisation, en partie autour du câble à tester CT, une pluralité de dispositifs de mesure 3, montés sur l'organe de support 2, et un calculateur 4 relié aux dispositifs de mesure 3.

En référence à la figure 2, l'organe de mesure 2 s'étend longitudinalement selon un axe principal I, latéralement selon un axe J et verticalement selon un axe K, de manière à former un repère orthogonal (I, J, K). L'organe de support 2 définit ainsi un plan transversal (J, K) à l'axe principal I. Dans cet exemple, le plan transversal (J, K) correspond à un plan médian de l'organe de support 2. Par souci de clarté, on définit par la suite un plan (I, J) orthogonal à l'axe vertical Z et qui s'étend ainsi horizontalement dans une configuration d'utilisation.

De manière préférée, dans la configuration d'utilisation représentée sur la figure 1, l'axe principal I de l'organe de mesure 2 et l'axe longitudinal X du câble à tester CT sont sensiblement confondus. En pratique, l'axe principal I de l'organe de mesure 2 forme avec l'axe longitudinal X du câble à tester CT un angle compris entre -5 et 5°.

Selon un aspect, l'organe de support 2 comprend une gorge 20 qui s'étend longitudinalement selon l'axe principal I. Par le terme « gorge », on entend un évidement formé dans l'organe de support 2. La gorge 20 est configurée pour permettre le passage du câble à tester CT, comme représenté sur la figure 1. A ce titre, dans cet exemple, la gorge 20 possède une forme semi-cylindrique. Il va de soi que la gorge 20 pourrait posséder une forme différente. En pratique, la forme de la gorge 20 est configurée, de préférence, pour être complémentaire de la forme du câble à tester CT.

Selon un aspect, l'organe de support 2 est configuré pour s'étendre, dans le plan transversal (J, K), au maximum en regard d'une moitié du câble à tester CT, de manière à limiter l'encombrement du système de mesure 1 autour du câble à tester CT. Autrement dit, l'organe de support 2 est configuré pour s'étendre, en périphérie du câble à tester CT, dans le plan transversal (J, K), selon un angle inférieur ou égal à 180°C, comme représenté sur la figure 2. En pratique, dans la configuration d'utilisation, l'organe de support 2 est configuré pour s'étendre uniquement en regard de la moitié supérieure CT-1 du câble à tester CT, de manière à permettre le passage d'un pantographe monté sur un véhicule ferroviaire sous le câble à tester CT.

De manière préférée, l'organe de support 2 présente une symétrie angulaire. Par « symétrie angulaire » on entend que l'organe de support 2 s'étend à une même distance radiale de la zone de test ZT afin de ne pas perturber le champ magnétique.

Dans cet exemple, l'organe de support 2 possède la forme d'un demi-cylindre circulaire droit creux. La gorge 20 correspond au creux du demi-cylindre circulaire. Autrement dit, l'organe de support 2 comprend dans cet exemple une section en forme de demi-disque. Il va de soi que l'organe de support 2 pourrait alternativement posséder une forme différente, par exemple la forme d'un parallélépipède de section carré.

Selon un aspect de l'invention, toujours en référence à la figure 2, le plan transversal (J, K) comprend une zone de test ZT. En pratique, la zone de test ZT s'étend, dans le plan transversal (J, K), dans la gorge 20. Autrement dit, le câble à tester CT est configuré pour s'étendre dans la zone de test ZT lors de son utilisation. Dans cet exemple, la zone de test ZT possède une forme circulaire possédant un rayon extérieur RE. En pratique, la zone de test ZT possède une forme complémentaire du câble à tester CT. Ainsi, de préférence le rayon extérieur RE de la zone de test ZT est sensiblement égal au rayon R du câble à tester CT, comme représenté sur la figure 3.

De manière préférée, l'organe de support 2 est fabriqué dans un matériau amagnétique, de manière à ne pas perturber le champ magnétique émis par le câble à tester CT et donc la mesure de courant. L'organe de support 2 est ainsi fabriqué, de préférence, dans un matériau plastique, par exemple du plexiglas ou dans un matériau polymère de type Acrylonitrile Butadiène Styrène, connu sous l'acronyme ABS. L'organe de support 2 est ainsi également léger.

Dans la configuration d'utilisation, l'organe de support 2 est maintenu au dessus du câble à tester CT par des organes de montage (non représentés), en particulier, des pinces ou mâchoires d'accrochage montées sur la caténaire. De telles mâchoires d'accrochage sont connues de l'homme du métier par exemple pour fixer un pendule de support de caténaires sur les voies ferrées.

Pour permettre la mesure de l'intensité de courant du câble à tester CT, le système de mesure 1 comprend une pluralité de dispositifs de mesure 3.

Chaque dispositif de mesure 31, 32, 33 est configuré pour mesurer un champ magnétique émis par le câble à tester CT. Dans cet exemple, les dispositifs de mesure 31, 32, 33 sont des capteurs de type à effet Hall. De tels capteurs sont connus de l'homme du métier et leur fonctionnement ne sera pas décrit plus en détails dans ce document. Il va de soi que les dispositifs de mesure 31, 32, 33 pourraient se présenter sous une forme différente, par exemple des bobines pour la mesure de courant alternatif, des magnétorésistances ou des capteurs de type « fluxgate ».

Par la suite, par souci de concision, la référence des dispositifs de mesure 31, 32, 33 sera notée de manière générale 3i.

En référence à la figure 2, les dispositifs de mesure 3i sont montés sur l'organe de support 2 dans le plan transversal (J, K) et positionnés à une même distance radiale D de la zone de test ZT. En pratique, la distance radiale D correspond à la distance mesurée radialement entre le barycentre du dispositif de mesure 3i et le centre B de la zone de test ZT. Autrement dit, les barycentres des dispositifs de mesure 3i forment un arc de cercle AC autour de la zone de test ZT. Dans cet exemple, la distance radiale D entre le centre B de la zone de test ZT et l'arc de cercle AC correspond à deux à cinq fois le rayon extérieur RE de la zone de test ZT, de manière à s'assurer d'une mesure fiable. Les dispositifs de mesure 3i sont également orientés radialement vers la zone de test ZT.

De manière préférée, les dispositifs de mesure 3i sont répartis angulairement autour de la zone de test ZT. En pratique, les dispositifs de mesure 3i sont répartis sur l'arc de cercle AC. Autrement dit, les dispositifs de mesure 3i sont repartis, dans cet exemple, sur une plage angulaire de 180° autour de la zone de test ZT. De préférence encore, les dispositifs de mesure 3i sont répartis de manière uniforme sur l'organe de support 2 autour de la zone de test ZT.

Toujours en référence à la figure 2, chaque dispositif de mesure 3i possède une position angulaire $\theta_i$ propre dans le plan transversal (J, K) par rapport à la zone de test ZT. Plus précisément, la position angulaire $\theta_i$ correspond à la position angulaire du barycentre du dispositif de mesure 3i concerné. Dans cet exemple, la position angulaire $\theta_i$ de chaque dispositif de mesure 3i est mesurée dans le plan transversal (J, K) par rapport à une position d'origine O sur l'arc de cercle AC formant un angle nul avec le plan horizontal (I, J), comme représentée sur la figure 2.

Selon un aspect, toujours en référence à la figure 2, le système de mesure 2 comprend au moins trois dispositifs de mesure 3i. En pratique, le nombre de dispositifs de mesure 3i dépend de la présence ou non d'un ou plusieurs câble(s) électrique(s) positionné(s) à proximité du câble à tester CT et susceptibles de perturber la mesure de courant. Un tel câble, dont un est représenté sur la figure 3, sera désigné par la suite « câble perturbateur CP ».

De manière préférée, lorsque le câble perturbateur CP est positionné à une distance du câble à tester CT (mesurée dans le plan transversal (J, K)) supérieure ou égale à dix fois la distance radiale D entre l'arc de cercle AC et la zone de test ZT, le système de mesure 1 comprend trois dispositifs de mesure 31, 32, 33, comme représenté sur les figures 2 et 3. Aussi, dans cet exemple dans lequel l'organe de support 2 possède la forme d'une portion de disque qui s'étend sur 180°, les dispositifs de mesure 31, 32, 33 sont, de préférence, répartis angulairement tous les 60°, par exemple à 30°, 90° et 150° à partir de la position d'origine O.

De manière alternative, en référence à la figure 4, lorsque le câble perturbateur CP est positionné à une distance du câble à tester CT (mesurée dans le plan transversal (J, K)), strictement inférieure à dix fois la distance radiale D (entre l'arc de cercle AC et la zone de test ZT), le système de mesure 1 comprend cinq dispositifs de mesure 31, 32, 33, 34, 35. Aussi, dans cet exemple dans lequel l'organe de support 2 possède la forme d'une portion de disque qui s'étend sur 180°, les dispositifs de mesure 31, 32, 33, 34, 35 sont de préférence répartis angulairement tous les 30°, par exemple à 30°, 60°, 90°, 120° et 150° à partir de la position d'origine O. Le système de mesure 1 pourrait alternativement comprendre un nombre de dispositifs de mesure 3i supérieur à cinq, par exemple un nombre compris entre six et neuf, de manière à s'assurer d'une mesure de courant fiable avec des redondances.

Selon un aspect de l'invention, comme décrit précédemment, chaque dispositif de mesure 3i est configuré pour mesurer une composante ortho-radiale COi du champ magnétique émis par le câble à tester CT. Chaque composante ortho-radiale COi possède une amplitude Si définie selon la formule suivante : $S_i(\theta_i) = C + A1 \cos(\theta_i + \delta\theta1) + \varepsilon_i$, dans laquelle C est un premier paramètre à déterminer, A1 est un deuxième paramètre à déterminer et $\delta\theta1$ est un troisième paramètre à déterminer.

En outre, le critère $\varepsilon_i$ est égal à $A2 \cos(2\theta_i + \delta\theta2)$, dans lequel A2 est un quatrième paramètre à déterminer et $\delta\theta2$ est un cinquième paramètre à déterminer.

En pratique, chaque dispositif de mesure 3i est configuré pour recevoir la composante ortho-radiale $CO_i$ du champ magnétique émis par le câble à tester CT et pour émettre un signal représentatif de cette composante ortho-radiale. L'amplitude Si du signal émis est reçue par un calculateur 4.

Dans une forme de réalisation, chaque dispositif de mesure 3i comprend un organe d'amplification, configuré pour augmenter l'amplitude Si du signal émis en réponse à la composante ortho-radiale CO reçue.

De manière préférée, chaque dispositif de mesure 3i comprend un organe de filtrage, de manière à supprimer des harmoniques des signaux générés et à améliorer la qualité du signal reçu par le calculateur 4. Il va de soi que d'autres étapes de traitement pourraient être mises en œuvre pour améliorer l'acquisition de l'amplitude Si.

En référence à la figure 2, calculateur 4 est relié à chaque dispositif de mesure 3i et est configuré pour recevoir, à un instant t donné, de chaque dispositif de mesure 3i, respectivement l'amplitude Si de chaque composante ortho-radiale COi. Autrement dit, le calculateur 4 est configuré pour recevoir une pluralité d'amplitudes Si, chacune étant fonction du positionnement angulaire $\theta_i$ et définie selon la formule décrite précédemment.

En particulier, lorsqu'un câble perturbateur CP est considéré comme étant éloigné de la zone de test ZT (c'est-à-dire positionné à une distance de la zone de test ZT supérieure ou égale à dix fois la distance radiale D), le critère $\varepsilon_i$ est considéré comme négligeable devant le premier paramètre C et le deuxième paramètre A1. Le système de mesure 1 comprend trois dispositifs de mesure 31, 32, 33. Le calculateur 4 est configuré pour recevoir trois amplitudes $S_1, S_2, S_3$ de composantes ortho-radiales COi : $S_1(\theta_1) = C + A1 \cos(\theta_1 + \delta\theta1)$, $S_2(\theta_2) = C + A1 \cos(\theta_2 + \delta\theta1)$, et $S_3(\theta_3) = C + A1 \cos(\theta_3 + \delta\theta1)$.

Lorsque le câble perturbateur CP est considéré comme étant proche de la zone de test ZT (c'est-à-dire positionné à une distance de la zone de test ZT inférieure à dix fois la distance radiale D), le critère $\varepsilon_i$ est considéré comme non-négligeable devant le premier paramètre C et le deuxième paramètre A1. Le système de mesure 1 comprend, dans cet exemple, cinq dispositifs de mesure 31, 32, 33, 34, 35. Le calculateur 4 est configuré pour recevoir cinq amplitudes $S_1, S_2, S_3, S_4, S_5$ de composantes ortho-radiales COi : $S_1(\theta_1) = C + A1 \cos(\theta_1 + \delta\theta1) + A2 \cos(2\theta_1 + \delta\theta2)$, $S_2(\theta_2) = C + A1 \cos(\theta_2 + \delta\theta1) + A2 \cos(2\theta_2 + \delta\theta2)$, $S_3(\theta_3) = C + A1 \cos(\theta_3 + \delta\theta1) + A2 \cos(2\theta_3 + \delta\theta2)$, $S_4(\theta_4) = C + A1 \cos(\theta_4 + \delta\theta1) + A2 \cos(2\theta_4 + \delta\theta2)$, $S_5(\theta_5) = C + A1 \cos(\theta_5 + \delta\theta1) + A2 \cos(2\theta_5 + \delta\theta2)$.

A partir des signaux Si reçus des dispositifs de mesure 3i, le calculateur 4 est configuré pour déterminer le premier paramètre C, le deuxième paramètre A1 et le troisième paramètre $\delta\theta1$ lorsque $\varepsilon_i$ est négligeable. En effet, les trois paramètres inconnus peuvent être aisément déterminés à partir des trois équations fournies par les trois dispositifs de mesure 3i.

A partir des signaux Si reçus des dispositifs de mesure 3i, le calculateur 4 est configuré pour déterminer le premier paramètre C, le deuxième paramètre A1, le troisième paramètre $\delta\theta1$, le quatrième paramètre A2 et le cinquième paramètre $\delta\theta2$ lorsque $\varepsilon_i$ est non-négligeable. En effet, les cinq paramètres inconnus peuvent être aisément déterminés à partir des cinq équations fournies par les cinq dispositifs de mesure 3i.

Selon un aspect, le calculateur 4 est alors configuré pour déterminer la valeur d'intensité I du courant électrique traversant le câble à tester CT à partir du premier paramètre C déterminé et de l'équation de courant : I = Q C. Dans cette équation, Q est une constante prédéterminée. Dans cet exemple, Q est déterminé par étalonnage du système de mesure 1 en plaçant ce dernier autour d'un câble électrique parcouru par un courant connu.

Dans une forme de réalisation, le système de mesure 1 comprend un multiplexeur, montée entre les dispositifs de mesure 3i et le calculateur 4 pour faciliter la communication des signaux Si au calculateur 4.

Grâce au système de mesure 1, l'intensité du courant électrique peut avantageusement être mesurée, même en présence d'un ou plusieurs câble(s) perturbateur(s) CP. La forme du système de mesure 1 permet son montage sur un câble électrique autour duquel l'espace est limité. Ainsi la mesure de courant électrique peut être réalisée sur une caténaire de voie ferrée, tout en permettant le passage d'un pantographe.

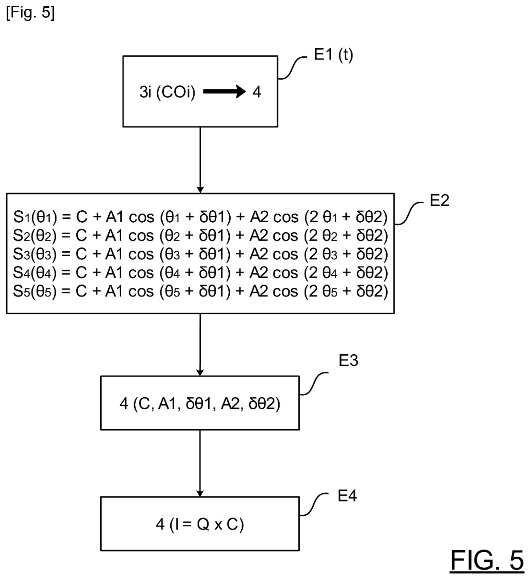

Il va dorénavant être décrit un procédé de mesure de l'intensité d'un courant électrique circulant dans un câble électrique à tester CT, en référence à la figure 5. Le procédé de mesure est mis en œuvre au moyen d'un système de mesure 1 tel que décrit précédemment et représenté sur la figure 4. Le câble à tester CT s'étend dans la gorge 20 de l'organe de support 2 et est ainsi monté dans la zone de test ZT, qui possède un rayon extérieur RE. Dans cet exemple, un câble perturbateur CP se trouve dans l'environnement du câble à tester CT et est positionné à une distance de la zone de test ZT inférieure à dix fois la distance radiale D entre le centre B de la zone de test ZT et l'arc de cercle AC formé par les barycentres des dispositifs de mesure 3i. Dans cet exemple, le système de mesure 1 comprend cinq dispositifs de mesure 31, 32, 33, 34, 35 répartis angulairement de manière uniforme autour de la zone de test ZT et positionnés à une même distance radiale D de la zone de test ZT. Chaque dispositif de mesure 31, 32, 33, 34, 35 possède une position angulaire $\theta_1$, $\theta_2$, $\theta_3$, $\theta_4$, $\theta_5$ prédéterminée.

Du fait de la circulation du courant électrique, le câble à tester CT émet un champ magnétique qui est reçu par les dispositifs de mesure 3i. Les dispositifs de mesure 3i étant répartis angulairement autour de la zone de test ZT à une même distance radiale D, ces derniers reçoivent le champ magnétique de manière simultanée.

Dans une première étape E1, à un instant donné t, chaque dispositif de mesure 3i mesure une composante ortho-radiale COi du champ magnétique émis par le câble à tester CT. Chaque composante ortho-radiale COi est reçue par le calculateur 4, qui est relié à chaque dispositif de mesure 3i, par exemple par un réseau de données.

Dans une deuxième étape E2, le calculateur 4 détermine pour chaque composante ortho-radiale COi reçue, une amplitude Si. Le calculateur 4 détermine alors, dans cet exemple, la pluralité d'équations suivantes :

$$-S_1(\theta_1) = C + A1 \cos (\theta_1 + \delta\theta1) + A2 \cos (2\,\theta_1 + \delta\theta2),$$

$$-S_2(\theta_2) = C + A1 \cos (\theta_2 + \delta\theta1) + A2 \cos (2\,\theta_2 + \delta\theta2),$$

$$-S_3(\theta_3) = C + A1 \cos (\theta_3 + \delta\theta1) + A2 \cos (2\,\theta_3 + \delta\theta2),$$

$$-S_4(\theta_4) = C + A1 \cos (\theta_4 + \delta\theta1) + A2 \cos (2\,\theta_4 + \delta\theta2),$$

$$-S_5(\theta_5) = C + A1 \cos (\theta_5 + \delta\theta1) + A2 \cos (2\,\theta_5 + \delta\theta2).$$

Le procédé comprend ensuite, une troisième étape E3 dans laquelle le calculateur 4 détermine, à partir des amplitudes Si mesurées par chaque dispositif de mesure 3i le premier paramètre C, le deuxième paramètre A1, le troisième paramètre $\delta\theta1$, le quatrième paramètre A2, le cinquième paramètre $\delta\theta2$.

Lorsque le premier paramètre C est déterminé, le calculateur 4 détermine, dans une quatrième étape E4, l'intensité du courant électrique circulant dans le câble à tester CT, à partir de l'équation de courant selon laquelle $I = Q \times C$. Dans cet exemple, le coefficient Q a été préalablement déterminé en montant le système de mesure 1 sur un câble électrique dont l'intensité est connue. Une telle étape est réalisée de manière analogue à la mesure du courant dans le câble à tester CT, seul le paramètre à déterminer dans l'équation de courant différant.

Grâce au système de mesure selon l'invention, l'intensité de courant électrique peut être mesurée de manière simple au moyen d'un système peu encombrant et qui peut être utilisé sur une caténaire de voie ferrée. Du fait du nombre de dispositifs de mesure et de l'utilisation d'une amplitude de composante ortho-radiale mesurée, la mesure est avantageusement fiable, même en présence d'un câble électrique à proximité.

## Revendications

1. Système de mesure (1) d'une intensité de courant électrique circulant dans un câble électrique à tester, ci-après désigné câble à tester (CT), le système de mesure (1) comprenant :

   - un organe de support (2) comprenant une gorge (20) s'étendant longitudinalement selon un axe principal (I) et configurée pour permettre le passage du câble à tester (CT), l'organe de support (2) définissant un plan transversal (J, K) à l'axe principal (I) qui comprend une zone de test (ZT), l'organe de support (2) s'étendant, dans le plan transversal (J, K), selon une plage angulaire autour de la zone de test (ZT) inférieure ou égale à 180°, le câble à tester (CT) étant configuré pour s'étendre dans la zone de test (ZT) lors de son utilisation,
   - au moins trois dispositifs de mesure (31, 32, 33) configurés pour mesurer un champ magnétique émis par le câble à tester (CT), les dispositifs de mesure (31, 32, 33) étant montés sur l'organe de support (2) dans le plan transversal (J, K) et répartis angulairement à une même distance radiale (R) de la zone de test (ZT),
   - chaque dispositif de mesure (3i) possédant une position angulaire ($\theta$i) propre dans le plan transversal (J, K) par rapport à la zone de test (ZT), chaque dispositif de mesure (3i) étant configuré pour mesurer une composante ortho-radiale (CO) du champ magnétique émis par le câble à tester (CT), et
   - un calculateur (4) relié à chaque dispositif de mesure (3),
   - le système de mesure (1) étant **caractérisé en ce que** la composante ortho-radiale (CO) mesurée par chaque dispositif de mesure (3i) ayant une amplitude (Si) définie selon la formule suivante : $Si(\theta i) = C + A1 \cos (\theta i + \delta\theta1) + \varepsilon_i$ dans laquelle :

- C est un premier paramètre à déterminer,
- A1 est un deuxième paramètre à déterminer, et
- $\delta\theta1$ est un troisième paramètre à déterminer,

le calculateur (4) est configuré pour :

- lorsque $\varepsilon_i$ est négligeable au regard du premier paramètre (C) et du deuxième paramètre (A1), déterminer le premier paramètre (C), le deuxième paramètre (A1) et le troisième paramètre ($\delta\theta1$) à partir des composantes ortho-radiales (CO) mesurées par les dispositifs de mesure (3i) à un instant (t) donné, et
- déterminer la valeur d'intensité (I) du courant électrique traversant le câble à tester (CT) à partir :

  ♣ du premier paramètre (C) déterminé, et

  ♣ de l'équation de courant : I = Q C, dans laquelle Q est une constante prédéterminée.

2. Système de mesure (1) selon la revendication 1, dans lequel le système de mesure (1) comprend au moins cinq dispositifs de mesure (3) configurés pour mesurer un champ magnétique émis par le câble à tester (CT),

- l'amplitude (Si) de la composante ortho-radiale (CO) mesurée par chaque dispositif de mesure (3i) étant définie selon la formule suivante : $Si(\theta i) = C + A1 \cos(\theta i + \delta\theta1) + \varepsilon i$ et $\varepsilon i$ étant égal à $A2 \cos(2\theta i + \delta\theta2)$ dans laquelle :

  - A2 est un quatrième paramètre à déterminer, et
  - $\delta\theta2$ est un cinquième paramètre à déterminer,

- le calculateur (4) étant configuré pour :

  - lorsque $\varepsilon i$ est non-négligeable au regard du premier paramètre (C) et du deuxième paramètre (A1), déterminer le premier paramètre (C), le deuxième paramètre (A1), le troisième paramètre ($\delta\theta1$), le quatrième paramètre (A2) et le cinquième paramètre ($\delta\theta2$) à partir des composantes ortho-radiales (CO) mesurées par les dispositifs de mesure (3i) à un instant (t) donné, et
  - déterminer la valeur d'intensité (I) du courant électrique traversant le câble à tester (CT).

3. Système de mesure (1) selon l'une des revendications 1 à 2, dans lequel les dispositifs de mesure (3i) sont répartis angulairement de manière uniforme sur l'organe de support (2) autour de la zone à tester (ZT).

4. Système de mesure (1) selon l'une des revendications 1 à 3, dans lequel le système de mesure (1) comprend un nombre de dispositifs de mesure (3i) compris entre six et neuf.

5. Système de mesure (1) selon l'une des revendications 1 à 4, dans lequel, la zone de test (ZT) possédant une forme circulaire possédant un rayon extérieur (RE), la distance radiale (D) entre chaque dispositif de mesure (3i) et le centre (B) de la zone de test (ZT) est comprise entre deux et cinq fois le rayon extérieur (RE) de la zone de test (ZT).

6. Système de mesure (1) selon l'une des revendications 1 à 5, dans lequel l'organe de support (2) présente une symétrie angulaire par rapport à la zone de test (ZT), de manière à permettre un positionnement symétrique des dispositifs de mesure (3) par rapport à la zone de test (ZT).

7. Système de mesure (1) selon l'une des revendications 1 à 6, dans lequel chaque dispositif de mesure (3) est un capteur à effet Hall.

8. Ensemble d'un câble à tester (CT) et d'un système de mesure (1) selon l'une des revendications 1 à 7, l'organe de support (2) étant monté autour du câble à tester (CT) de manière à mesurer l'intensité du courant électrique traversant le câble à tester (CT).

9. Procédé de mesure d'une intensité du courant électrique circulant dans un câble à tester (CT) au moyen du système de mesure (1) selon l'une des revendications 1 à 7, un câble à tester (CT) étant monté dans la zone à tester (ZT), le procédé comprenant une étape consistant à mesurer (E1), à un instant (t) donné, par chaque dispositif de mesure (3i), une composante ortho-radiale (CO) du champ magnétique émis par le câble à tester (CT), le procédé de mesure étant **caractérisé en ce qu'**il comprend les étapes consistant à :

- déterminer (E3) au moins le premier paramètre (C), le deuxième paramètre (A1) et le troisième paramètre ($\delta\theta1$) à partir des composantes ortho-radiales (CO) mesurées ayant une amplitude (Si) définie selon la formule suivante : $Si(\theta i) = C + A1 \cos(\theta i + \delta\theta1) + \varepsilon_i$, et
- déterminer (E4) la valeur d'intensité (I) du courant électrique traversant le câble à tester (CT) à partir du premier paramètre (C) et de l'équation de courant : $I = Q\,C$, dans laquelle Q est une constante prédéterminée.

10. Procédé de mesure selon la revendication 9, dans lequel, lorsque $\varepsilon i$ est non négligeable au regard du premier paramètre (C) et du deuxième paramètre (A1), l'étape de détermination (E3) détermine le premier paramètre (C), le deuxième paramètre (A1), le troisième paramètre ($\delta\theta1$), le quatrième paramètre (A2) et le cinquième paramètre ($\delta\theta2$).

[Fig. 1]

FIG. 1

[Fig. 2]

FIG. 2

[Fig. 3]

FIG. 3

[Fig. 4]

FIG. 4

[Fig. 5]

E1 (t)

3i (COi) ⟶ 4

E2

$S_1(\theta_1) = C + A1 \cos(\theta_1 + \delta\theta1) + A2 \cos(2\theta_1 + \delta\theta2)$
$S_2(\theta_2) = C + A1 \cos(\theta_2 + \delta\theta1) + A2 \cos(2\theta_2 + \delta\theta2)$
$S_3(\theta_3) = C + A1 \cos(\theta_3 + \delta\theta1) + A2 \cos(2\theta_3 + \delta\theta2)$
$S_4(\theta_4) = C + A1 \cos(\theta_4 + \delta\theta1) + A2 \cos(2\theta_4 + \delta\theta2)$
$S_5(\theta_5) = C + A1 \cos(\theta_5 + \delta\theta1) + A2 \cos(2\theta_5 + \delta\theta2)$

E3

4 (C, A1, δθ1, A2, δθ2)

E4

4 (I = Q x C)

FIG. 5

**RAPPORT DE RECHERCHE EUROPEENNE**

Numéro de la demande

EP 25 22 4142

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | FR 3 143 130 A1 (NEXANS [FR]) 14 juin 2024 (2024-06-14) * alinéas [0001], [0041] - [0060]; figure 3 * | 1-10 | INV. G01R15/20 |
| A | CN 110 412 339 A (ELECTRIC POWER RES INST CO LTD CSG; CHINA SOUTHERN POWER GRID CO) 5 novembre 2019 (2019-11-05) * figure 2 * | 1-10 | |
| A | US 2003/151406 A1 (WAN HONG [US] ET AL) 14 août 2003 (2003-08-14) * figure 4 * | 1-10 | |
| A | US 2024/125819 A1 (SCHERER AXEL [US] ET AL) 18 avril 2024 (2024-04-18) * figure 1 * | 1-10 | |

**DOMAINES TECHNIQUES RECHERCHES (IPC)**

G01R

Le présent rapport a été établi pour toutes les revendications

| Lieu de la recherche | Date d'achèvement de la recherche | Examinateur |
|---|---|---|
| Munich | 14 avril 2026 | Jedlicska, István |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
..............................................................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 25 22 4142

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

14-04-2026

| Document brevet cité au rapport de recherche | | Date de publication | Membre(s) de la famille de brevet(s) | | Date de publication |
|---|---|---|---|---|---|
| FR 3143130 | A1 | 14-06-2024 | CN | 120359426 A | 22-07-2025 |
| | | | EP | 4630827 A1 | 15-10-2025 |
| | | | FR | 3143130 A1 | 14-06-2024 |
| | | | WO | 2024121518 A1 | 13-06-2024 |
| CN 110412339 | A | 05-11-2019 | AUCUN | | |
| US 2003151406 | A1 | 14-08-2003 | AU | 2003215132 A1 | 04-09-2003 |
| | | | CA | 2476243 A1 | 21-08-2003 |
| | | | EP | 1481256 A2 | 01-12-2004 |
| | | | JP | 2005517937 A | 16-06-2005 |
| | | | KR | 20040081200 A | 20-09-2004 |
| | | | US | 2003151406 A1 | 14-08-2003 |
| | | | WO | 03069690 A2 | 21-08-2003 |
| US 2024125819 | A1 | 18-04-2024 | EP | 4599259 A1 | 13-08-2025 |
| | | | US | 2024125819 A1 | 18-04-2024 |
| | | | WO | 2024076760 A1 | 11-04-2024 |

EPO FORM P0460

Pour tout renseignement concernant cette annexe : voir Journal Officiel de l'Office européen des brevets, No.12/82

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 3143130 A1
- CN 110412339 A
- US 20030151406 A1
- US 2024125819 A1